# EUROPEAN PATENT APPLICATION

(11) **EP 4 557 365 A1**
(43) Date of publication of application: **21.05.2025**
(21) Application number: 23209987.9
(22) Date of filing: 15.11.2023
(51) Int. Cl.: H01L 23/528, G06F 1/10, H01L 27/118

(54) **INTEGRATED CIRCUIT DEVICE**

(71) Applicant: Imec VZW, 3001 Leuven (BE)
(72) Inventor: MYERS, James Edward, Great Wibraham, CB21 5JD (GB); HELLINGS, Geert, 1500 Halle (BE)
(74) Representative: Lind Edlund Kenamets Intellectual Property AB

(57) **Abstract**

There is provided an integrated circuit device (10). The integrated circuit device (10) comprises a clock distribution network (30) comprising a clock mesh (32) formed by a first set of parallel clock lines (34) and a second set of parallel clock lines (36), wherein the first and second sets of clock lines (34, 36) are arranged at a same level (BSM2) in a backside interconnect structure (20) of the integrated circuit device (10) and are interconnected by crossing each other.

## Description

### TECHNICAL FIELD

The present invention generally relates to an integrated circuit device comprising a clock distribution network.

### BACKGROUND

Clock distribution networks are a critical part of state-of-the-art digital integrated circuit devices, such as synchronous digital systems-on-chip (SOCs). The networks cover a large chip area which means they cost a lot of power (by way of example approximately 30% of SOC power consumption is due to the clock distribution). The clock distribution is also important for performance. Due to factors such as variability in buffer delay and parasitic capacitances, skew may accumulate in clock signals as they spread out across a chip. Clock skew is the difference in arrival times of clock edges between different parts of the IC. Hence, one challenge facing integrated circuit designers is to minimize or mitigate clock skew, such that each active device is kept at the same pace e.g., to avoid delays that otherwise can cause malfunctions of the IC.

In high performance circuit designs, clock meshes may be used instead of clock trees to reduce clock skew. However, clock meshes as conventionally designed tend to consume more power compared to clock trees. Further, conventional clock meshes occupy valuable space in the front side BEOL interconnect structure which is used to interconnect and route signals (e.g. logic input and output signals) between the active devices of the ICs (e.g. configured to define logic gates, flip-flops or registers). Moreover, conventional clock meshes may increase the competition for routing resources in the front side BEOL interconnect structure which also are needed for routing non-clock signals (e.g. logic input and output signals) between the active devices of the ICs (e.g. configured to define logic gates, flip-flops or registers). Hence, there is room for improvement when it comes to clock distribution in an IC.

### SUMMARY

It is an object of the present invention to provide an IC device which solves or at least alleviates at least some of the above drawbacks of conventional clock mesh implementations.

Hence, it is an object to provide an IC device comprising a clock distribution network in the form of a clock mesh enabling low clock skew and reduced power consumption.

Another object is to provide an IC device comprising a clock mesh implemented to enable reduced competition for routing resources in the front side BEOL.

Another object is to provide an IC device comprising a clock mesh implemented so as to enable rational and cost-effective fabrication.

These and other objects may be achieved by an IC device in accordance with the independent claim. Embodiments of the present invention are defined in the dependent claims.

Hence, according to an aspect of the present invention, there is provided an integrated circuit device comprising:
a clock distribution network comprising a clock mesh formed by a first set of parallel clock lines and a second set of parallel clock lines, wherein the first and second sets of clock lines are arranged at a same level in a backside interconnect structure of the IC device and are interconnected by crossing each other

Thus, the present invention is based on the insight that providing the clock mesh in the backside interconnect structure may reduce competition for routing resources in the front side BEOL interconnect structure (hereinafter the term BEOL may be omitted for brevity), such that more resources remain available for routing non-clock signals in the front side interconnect structure.

Further, by moving the clock mesh to the backside interconnect structure, there is a reduced risk that the clock signals propagating in the clock mesh will introduce noise into non-clock logic signals conveyed in the front side interconnect structure.

Furthermore, by moving the clock mesh to the backside interconnect structure, the clock mesh may be located closer to an active device region of the integrated circuit, such that shorter signal path lengths may be realized as compared to a traditional clock mesh provided in the front side interconnect structure.

Moreover, according to the IC device of the first aspect, the first and second sets of clock lines are arranged at a same level in the backside interconnect structure. The first and second clock lines are hence merged or collapsed into a single common metallization layer of the backside interconnect structure.

The single-layer and crossing arrangement of the first and second clock lines obviate the need for vertical via connections between the first and second sets of clock lines, such that shorter signal path lengths may be realized. This may contribute to both reduced clock skew and more rational and cost-effective fabrication. Moreover, the crossing arrangement of the first and second sets of clock lines may provide a reduced resistance at the crossings by providing an increased contact interface between the lines as compared to a conventional via connection.

By "at a same level" is here meant that the first and second sets of clock lines are arranged at a same distance from a nominal reference plane or surface. Hence, the first and second sets of clock lines are arranged at a same vertical level or height with respect to e.g., a front side or backside of a substrate of the IC device. This means in practice that the first and second sets of clock lines extend in the same plane (i.e. horizontal plane parallel to the substrate) such that the first and second sets of clock lines naturally become interconnected at locations where they cross each other.

According to some embodiments, the first set of clock lines may extend along a first direction and the second set of clock lines may extend along a second direction transverse to the first direction, which is advantageous in that interconnecting the clock mesh to other parts, such as active components, of the IC device may be facilitated.

By "transverse to" is here meant that the first and second directions are orthogonal or substantially orthogonal such that the first set of clock lines extend orthogonally or substantially orthogonally to the second set of clock lines.

According to some embodiments, the backside interconnect structure may further comprise a power distribution network, which is advantageous in that competition for routing resources in the front side interconnect structure may be further reduced.

According to some embodiments, the power distribution network may comprise a first set of power rails and a second set of power rails, wherein the clock mesh, the first set of power rails and the second set of power rails are arranged at different respective levels in the backside interconnect structure. By providing the power rails and the clock mesh at different respective levels in the backside interconnect structure, the clock and power distribution may be collocated in the backside interconnect structure with a reduced capacitive coupling between the power rails and the clock lines. Power rails are typically formed as high aspect ratio metal lines. Hence, if arranged side-by-side with clock lines, the capacitive coupling to the power rails may significantly increase the capacitance of the clock distribution network. However, by arranging the clock mesh and the first and second sets of power rails at different levels, a horizontal interface between clock lines and power rails may be avoided.

By "first set of power rails" is here meant the set of power rails being closer to a substrate of the IC device, the substrate supporting the backside interconnect structure. Hence, the first set of power rails is closer to a substrate supporting the backside interconnect structure as compared to the second set of power rails. Consequently, by "second set of power rails" is here meant the set of power rails being farther away from a substrate supporting the backside interconnect structure.

According to some embodiments, the power rails of the first set of power rails may alternatingly be VSS and VDD power rails, and the power rails of the second set of power rails may alternatingly be VSS and VDD power rails, which is advantageous in that both VSS and VDD power rails may be available for access along both the first and second directions.

According to some embodiments, the clock mesh may be arranged at a level between the first and second sets of power rails, which is advantageous in that the power rails may shield the clock lines from surrounding circuitry, further counteracting noise caused by the clock signals propagating in the clock mesh from interfering with non-clock logic signals conveyed in the front side interconnect structure.

According to some embodiments, the clock mesh, the first set of power rails and the second set of power rails may be arranged in consecutive metallization layers of the backside interconnect structure, which is advantageous in that a compact solution using a limited number of metal layers may be realized.

According to some embodiments, the first set of clock lines and the first set of power rails may extend along a first direction and the second set of clock lines and the second set of power rails may extend along a second direction transverse to the first direction, which is advantageous in that clock lines and power rails may be available along two transverse directions.

According to some embodiments, the first set of power rails may be arranged at a first power rail pitch and the first set of clock lines may be arranged at a first clock line pitch defined by one or more integer multiples of the first power rail pitch, and wherein the second set of clock lines may be arranged at a second clock line pitch and the second set of power rails may be arranged at a second power rail pitch defined by one or more integer multiples of the second clock line pitch. Hence, the electrical properties of the clock mesh and the power distribution network may be consistent throughout the IC device, thus further maintaining a small mutual capacitive coupling.

According to some embodiments, the first set of power rails may be offset along the second direction with respect to the first set of clock lines, and/or the second set of power rails may be offset along the first direction with respect to the second set of clock lines, which is advantageous in that the crossings in the clock mesh may be located in the gaps between the power rails. This arrangement may facilitate arranging vias, such as clock vias, in the gaps between the power rails.

According to some embodiments, the offset of the first set of power rails with respect to the first set of clock lines may be substantially equal to half of the first power rial pitch, and the offset of the second set of power rails with respect to the second set clock lines may be substantially equal to half of the second clock line pitch, which is advantageous in that the power rails of the first set of power rails may be located substantially at the center of the gaps in the clock mesh, and that the crossings of the clock mesh may be located substantially at the center of the gaps between the power rails of the second set of power rails. This arrangement may facilitate arranging vias, such as clock vias from or to the clock mesh, in the gaps between the first or second power rails. Similarly, this arrangement may facilitate arranging vias, such as power vias between the second and first power rails, in the gaps between the clock lines. Further, a capacitive coupling between the, the first and second set of clock lines, and the first and second set of power rails may be further reduced.

According to some embodiments, the backside interconnect structure may further comprise at least one power via connected to a power rail of the first set of power rails and to a power rail of the second set of power rails and extending through an opening in the clock mesh. Hence, active components may be powered without being blocked by the clock mesh. Further, power may be distributed between different levels of the power distribution network without being blocked by the clock mesh.

According to some embodiments, the backside interconnect structure may further comprise at least one clock via connected to the clock distribution network and extending through an opening in the first set of power rails. Hence, a clock signal may be distributed to active components of the integrated circuit without being blocked by the first set of power rails.

According to some embodiments, the IC device may further comprise a substrate supporting, on a frontside thereof, an active device region, and a frontside interconnect structure arranged above the active device region, wherein the backside interconnect structure is arranged on a backside of the substrate.

According to some embodiments, the at least one clock via may extend through the substrate and be connected to clock driver circuitry of the active device region. Hence, the clock distribution network of the backside interconnect structure may receive and distribute a clock signal which is generated on the front side of the substrate by the clock driver circuitry of the active device region.

### BRIEF DESCRIPTION OF THE DRAWINGS

This and other aspects of the present invention will now be described in more detail, with reference to the appended drawings showing embodiments of the present invention.
Fig. 1 schematically shows a cross-sectional view of an integrated circuit device comprising an active device region and a frontside interconnect structure arranged on a frontside of a substrate and a backside interconnect structure arranged on a backside of the substrate.
Fig. 2 schematically shows an isometric three-dimensional view of a portion of the backside interconnect structure of the integrated circuit device of Fig. 1.

### DETAILED DESCRIPTION

Example embodiments of an integrated circuit (IC) device comprising a clock distribution network comprising a clock mesh will in the below be described with reference to the drawings. The drawings are only schematic and the relative dimensions of some structures and layers may be exaggerated and not drawn to scale. Rather the dimensions may be adapted for illustrational clarity and to facilitate understanding. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to (a main surface of) a substrate of the integrated circuit device. The term "vertical" refers to a direction parallel to a normal direction of (a main surface of) a substrate which in practice supports the active region of the integrated circuit device, i.e., transverse to the substrate. Further, the (positive) vertical direction refers to a direction which points out of what typically is regarded as a front side of the substrate. This means that subsequent layers of the back backside interconnect structure are arranged one after the other in a negative vertical direction, i.e., a direction which is opposite to the vertical direction. In other words, subsequent layers of the back backside interconnect structure are arranged one after the other on the backside of the substrate and hence in a direction opposite to the direction indicated by the axis Z.

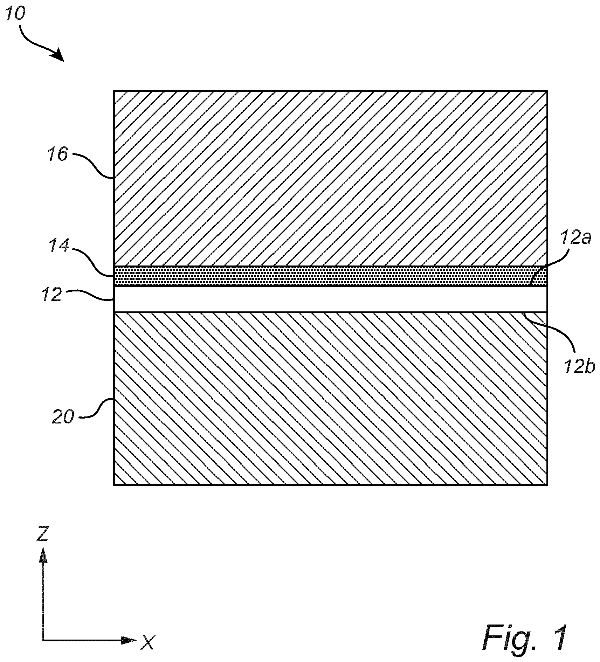

Fig. 1 schematically illustrates an exemplary IC device 10 according to an embodiment. The depicted IC device 10 is formed starting from a substrate 12. Hence, the IC device 10 includes a substrate 12. The substrate 12 may have been thinned during the formation of the IC device 10. Hence, the shown portion of the substrate 12 may correspond to a thickness portion of an initial thickness of the substrate 12 remaining after thinning.

The substrate 12 may as shown support an active device region 14 on a front side 12a thereof. In other words, an active device region 14 may be formed on the frontside 12a of the substrate 12 as illustrated in Fig. 1. The active device region 14 may include any type of active components, such as transistors, formed on the front side 12a of the substrate 12. The active components may be configured to provide various functions, such as to define logic gates, flip-flops or registers. The active device region 14 may also be referred to as a front-end-of-line portion (FEOL-portion 14).

A frontside interconnect structure 16 may as shown be arranged vertically above the active device region 14 of the IC device 10. The frontside interconnect structure 16 may as is known in the art typically include a plurality of metallization layers, including conductive lines arranged in a dielectric layer structure of one or more interlayer dielectric materials, and vias connecting the conductive lines of the metallization layers of the frontside interconnect structure 16. The frontside interconnect structure 16 may thus typically be configured to interconnect the active components of the active device region 14.

A backside interconnect structure 20 may as shown be arranged on a backside 12b of the substrate 12. The backside interconnect structure 20 may generally have a structure corresponding to the frontside interconnect structure 16, and thus comprise a plurality of metallization layers, including conductive lines arranged in a dielectric layer structure, and vias connecting the conducting lines of the metallization layers of backside interconnect structure 20. Vias of the backside interconnect structure 20 may typically also extend through the substrate 12 to e.g., provide power or a clock signal to the active components of the active device region 14. Further, the active device region 14 may include clock driver circuitry. The clock driver circuitry may be configured to generate a clock signal. Such clock signal may be provided to the backside interconnect structure 20 by vias extending through the substrate 12, and then provided to the active components of the active device region 14 by vias extending through the substrate 12. Examples of interlayer dielectric materials include silicon oxide, or other low-k dielectrics conventionally used in front- and backside interconnect structures. Examples of conductive materials of the conductive lines and vias include aluminum, tungsten, ruthenium, or gold, silver, and combinations thereof.

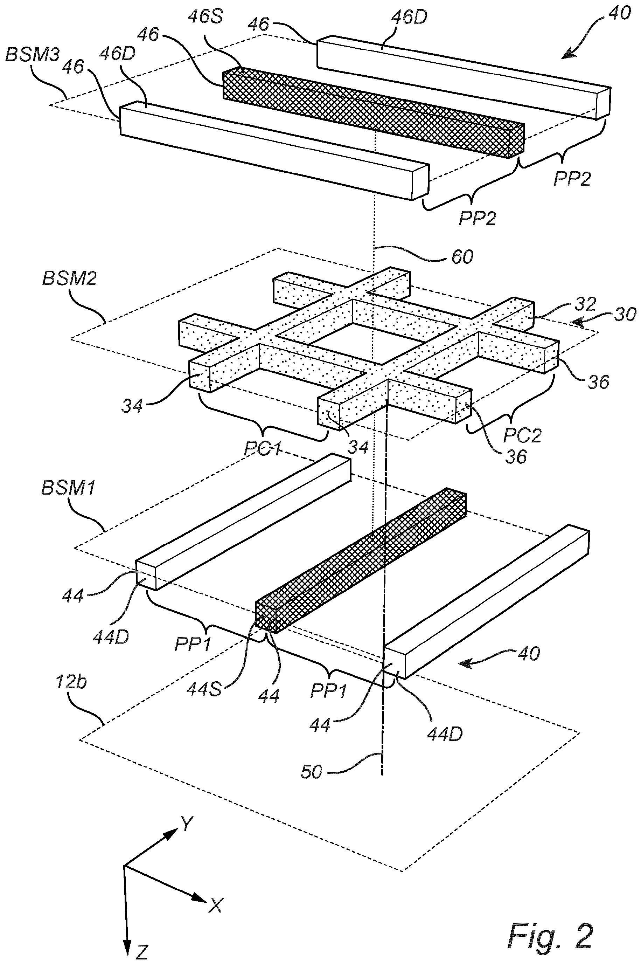

Now also referring to Fig. 2, there is schematically illustrated a portion of the backside interconnect structure 20 of the IC device 10 depicted in Fig. 1. In other words, Fig. 2 illustrates an exemplary design of the backside interconnect structure 20. The dielectric layer structure embedding the conductive lines of the metallization layers is omitted from Fig. 2, to indicate the design of the metallization layers more clearly.

The depicted backside interconnect structure 20 includes a clock distribution network 30. The clock distribution network 30 comprises a clock mesh 32. The clock mesh 32 is formed by a first set of parallel clock lines 34 and a second set of parallel clock lines 36 as illustrated in Fig. 2. Hence, the clock lines 34 of the first set of parallel clock lines 34 may extend in parallel to each other. Correspondingly, the clock lines 36 of the second set of parallel clock lines may 36 extend in parallel to each other.

The first set of clock lines 34 and the second set of clock lines 36 may be formed as conductive lines 34, 36 (e.g., of any of the example metals mentioned above) arranged in a dielectric layer.

As illustrated in Fig. 2, the first set of clock lines 34 and the second set of clock lines 36 of the backside interconnect structure 20 are arranged at a same level in the backside interconnect structure 20. Further, the first set of clock lines 34 and the second set of clock lines 36 are interconnected by crossing each other. Hence, the first set of clock lines 34 and the second set of clock lines 36 may form part of a same metallization layer BSM2 of the backside interconnect structure 20.

The first set of clock lines 34 and the second set of clock lines 36 may be formed simultaneously (e.g., during BEOL processing of the IC device fabrication). More specifically, the first set of clock lines 34 and the second set of clock lines 36 may be formed simultaneously in a damascene style processing where trenches crisscrossing each other are formed in a dielectric layer and subsequently filled by one or more metals. Such crisscrossing trenches may be formed by lithography and etching or by any other suitable patterning technique. Alternatively, the first set of clock lines 34 and the second set of clock lines 36 may be formed simultaneously by a direct metal etch, in which a metal layer is blanket deposited and then etched such that portions forming the first set of clock lines 34 and the second set of clock lines 36 are kept while other portions of the metal layer are removed by being etched away. While forming the first and second clock lines 34, 36 simultaneously may contribute to an efficient fabrication process, a staggered process is also possible. For instance, in a damascene style process the first clock lines 34 may be formed first and then the second clock lines 36, or vice versa.

As illustrated in Fig. 2, the first set of clock lines 34 may extend along a first lateral direction Y. Hence, the first set of clock lines 34 may extend along the axis Y as indicated in Fig 2. The second set of clock lines 36 may extend along a second lateral direction X as indicated in Fig 2. The second lateral direction X of the second set of clock lines 34 may be transverse to the first lateral direction Y of the first set of clock lines 34. In other words, the first set of clock lines 34 and the second set of clock lines 36 may extend substantially perpendicular to each other in a plane which is parallel to the backside 12b of the substrate 12.

The backside 12b of the substrate 12 is indicated by a hatched rectangle in Fig. 2 to illustrate the location of the substrate 12 in relation to the features of back side interconnect structure 20. In this regard, it is to be noted that the axis Z points downwards in Fig. 2 whereas the axis Z points upwards in Fig. 1.

The depicted backside interconnect structure 20 may as shown further include a power distribution network 40. The power distribution network 40 may generally be configured to provide power to the active device region 14 of the IC device 10. The power distribution network 40 may be formed as conductive lines (e.g., of any of the example metal mentioned above) arranged in a dielectric layer. The power distribution network 40 may be formed in a damascene style processing or in a direct metal etch, like the first set of clock lines 34 and the second set of clock lines 36.

The power distribution network 40 of Fig. 2 may as shown include a first set of power rails 44 and a second set of power rails 46. The first set of power rails 44, the second set of power rails 46, and the clock mesh 30 are arranged at different respective levels in the backside interconnect structure 20. This means that the clock mesh 30, the first set or power rails 44 and the second set of power rails 46 may form part of different respective metallization layers BSM2, BSM1, BSM3 of the backside interconnect structure 20.

More specifically, the first set of power rails 44 may be provided closer to the substrate 12 of the IC device 10 than the clock mesh 30 and the second set of power rails 46. The clock mesh 32 may be arranged at a level between the first and second sets of power rails 44, 46. In other words, the second set of power rails 46 may be arranged at a level farther away from the substrate 12 than the clock mesh 32 and the first set of power rails 44. In particular, the first set of power rails 44, the clock mesh 32 and the second set of power rails 46 may as shown be arranged in consecutive metallization layers BSM1, BSM2, BSM3 of the backside interconnect structure 20.

As illustrated in Fig. 2, the first set of power rails 44 may extend along the first lateral direction Y. Hence, the first set of power rails 44 may extend along the axis Y as indicated in Fig 2. The second set of power rails 46 may extend along the second lateral direction X as indicated in Fig 2. In other words, the first set of power rails 44 and the second set power rails 46 of the depicted backside interconnect structure 20 may extend substantially perpendicular to each other in a plane which is parallel to the backside 12b of the substrate 12.

Hence, in the backside interconnect structure 20 of Fig. 2, the first set of clock lines 34 and the first set of power rails 44 may extend along the first direction Y and the second set of clock lines 36 and the second set of power rails 46 may extend along the second direction X which is transverse to the first direction Y.

As illustrated in Fig. 2, the first set of power rails 44 may alternatingly be VSS and VDD power rails 44S, 44D. Correspondingly, as illustrated in Fig. 2 the power rails of the second set of power rails 46 may alternatingly be VSS and VDD power rails 46S, 46D. The terms VSS and VDD power rails here refer to power rails configured to provide a lower supply voltage (e.g., a reference voltage) and a higher supply voltage, respectively. The lower supply voltage may for instance correspond to a ground voltage (GND).

As illustrated in Fig. 2, the first set of clock lines 34 may be arranged at a first clock line pitch PC1. In other words, a center-to-center distance of consecutive clock lines 34 of the first set of clock lines 34 may be the same distance PC1 throughout the first set of clock lines 34. Correspondingly, the second set of clock lines 36 may be arranged at a second clock line pitch PC2. In other words, a center-to-center distance of consecutive clock lines 36 of the second set of clock lines 36 may be the same distance PC2 throughout the second set of clock lines 36. The first clock line pitch PC1 may be equal to the second clock line pitch PC2. The first clock line pitch PC1 may be smaller than the second clock line pitch PC2. The first clock line pitch PC1 may be larger than the second clock line pitch PC2.

As illustrated in Fig. 2, the first set of power rails 44 may be arranged at a first power rail pitch PP1. In other words, a center-to-center distance of consecutive power rails 44 of the first set of power rails 44 may be the same distance PP 1 throughout the first set of power rails 44. Correspondingly, the second set of power rails may be arranged at a second power rail pitch PP2. In other words, a center-to-center distance of consecutive power rails 46 of the second set of power rails 46 may be the same distance PP2 throughout the second set of power rails 46. The first power rail pitch PP1 may be equal to the second power rail pitch PP2. The first power rail pitch PP1 may be smaller than the second power rail pitch PP2. The first power rail pitch PP1 may be larger than the second power rail pitch PP 1.

Further, the first clock line pitch PC 1 may be defined by one or more integer multiples of the first power rail pitch PP1. Hence, when the first set of power rails 44 are arranged at a first power rail pitch PP1, the first set of clock lines 34 may be arranged at a first clock line pitch PC1 which is equal to the first power rail pitch PP1, or the at a first clock line pitch PC1 which is corresponds to an integer number times the first power rail pitch PP1. In other words, the first clock line pitch PC1 may be 1, 2, 3, 4, ... N times the first power rail pitch PP1.

Further, the second power rail pitch PP2 may be defined by one or more integer multiples of the second clock line pitch PC2. Hence, when the second set of clock lines 36 are arranged at a second clock line pitch PC2, the second set of power rails 46 may be arranged at a second power rail pitch PP2 which is equal to the second clock line pitch PC2, or the at a second power rail pitch PP2 which is corresponds to an integer number times the second clock line pitch PC2. In other words, second power rail pitch PP2 may be 1, 2, 3, 4, ... N times the second clock line pitch PC2.

As illustrated in Fig. 2, the first set of power rails 44 may be offset along the second direction X with respect to the first set of clock lines 34. Correspondingly, the second set of power rails 46 may be offset along the first direction Y with respect to the second set of clock lines 36. More specifically, the offset of the first set of power rails 44 with respect to the first set of clock lines 34 may be substantially equal to half of the first power rail pitch PP1. Correspondingly, the offset of the second set of power rails 46 with respect to the second set clock lines 36 may be substantially equal to half of the second clock line pitch PC2.

By offsetting, the first set of power rails 44 along the second direction X with respect to the first set of clock lines 34, a clock via 50 may be provided from the clock mesh 32 to the backside 12b of substrate 12. Such a clock via 50 may consequently provide a clock signal from the clock mesh 32 to the active device region 14 of the IC device 10 by extending through the substrate 12. Alternatively, the clock via 50 may be connected to clock driver circuitry of the active device region 14 by the clock via 50 extending through the substrate 12. In this way, a clock signal generated by the clock diver circuitry of the active device region 14 may be provided to the clock mesh 32 of the backside interconnect structure 20. Hence, a clock signal generated by the clock diver circuitry of the active device region 14 may be provided to the clock mesh 32 of the backside interconnect structure 20 by means of a first clock via 50 and then provided to one or more active components of the active device region 14 by a second clock via 50. In Fig. 2, the clock via 50 is generally indicated by a hatched line 50 extending from an interconnection point between a clock line 34 of the first set of parallel clock lines 34 and a clock line 36 of the second set of parallel clock lines 36 to the backside 12b of substrate 12. As illustrated in Fig. 2, the clock via 50 extends through the center of the opening formed between two adjacent power rails 44 of the first set of power rails 44, since the offset of the first set of power rails 44 with respect to the first set of clock lines 34 in Fig. 2 is substantially equal to half of the first power rail pitch PP1.

Further, by additionally offsetting, the second set of power rails 46 along the first direction Y with respect to the second set of clock lines 36, a power via 60 may be provided from the first set of power rails 44 to the second set of power rails 46. Such a power via 60 may consequently interconnect a VSS power rail 44S of the first set of power rails 44 with a VSS power rail 46S of the second set of power rails 46 as indicated in Fig. 2. Analogously, such a power via 60 may interconnect a VDD power rail 44D of the first set of power rails 44 with a VDD power rail 46D of the second set of power rails 46, not shown in Fig. 2. In this way, power may be distributed between the first set of power rails 44 and the second set of power rails 46. In Fig. 2, the power via 60 is generally indicated by a hatched line 60 extending from a power rail 44 of the first set of power rails 44 to a power rail 46 of the second set of power rails 46. As illustrated in Fig. 2, the power via 60 extends substantially through the center of the opening formed between two adjacent clock lines 34 of the first set of clock lines 34 and two adjacent clock lines 36 of the second set of clock lines 36, since the offset of the second set of power rails 46 with respect to the second set of clock lines 36 in Fig. 2 is substantially equal to half of the second power rail pitch PP2.

The person skilled in the art realizes that the present invention by no means is limited to the embodiments described above. On the contrary, many modifications and variations are possible within the scope of the appended claims. For example, the back side interconnect structure 20 may include further metallization layers apart from the metallization layers BSM1, BSM2, BSM3 illustrated in Fig. 2. That is, the metallization layers BSM1-BSM3 shown in Fig. 2 may represent a subset of the metallization layers of the backside interconnect structure 20. Also, while in Fig. 2 the line pitch of the different metallization layers BSM1-BSM3 is uniform, the line pitch may become larger when moving away from the backside of the substrate.

## Claims

1. An integrated circuit device (10) comprising:
a clock distribution network (30) comprising a clock mesh (32) formed by a first set of parallel clock lines (34) and a second set of parallel clock lines (36), wherein the first and second sets of clock lines (34, 36) are arranged at a same level (BSM2) in a backside interconnect structure (20) of the integrated circuit device (10) and are interconnected by crossing each other.

2. The integrated circuit device (10) according to claim 1, wherein the first set of clock lines (34) extend along a first direction (Y) and the second set of clock lines (36) extend along a second direction (X) transverse to the first direction (Y).

3. The integrated circuit device (10) according to any one of the preceding claims, wherein the backside interconnect structure (20) further comprises a power distribution network (40).

4. The integrated circuit device (10) according to claim 3, wherein the power distribution network (40) comprises a first set of power rails (44) and a second set of power rails (46), wherein the clock mesh (30), the first set or power rails (44) and the second set of power rails (46) are arranged at different respective levels (BSM2, BSM1, BSM3) in the backside interconnect structure (20).

5. The integrated circuit device (10) according to claim 4, wherein the power rails of the first set of power rails (44) are alternatingly VSS and VDD power rails (44S, 44D), and wherein the power rails of the second set of power rails (46) are alternatingly VSS and VDD power rails (46S, 46D).

6. The integrated circuit device (10) according to any one of claims 4-5, wherein the clock mesh (32) is arranged at a level (BSM2) between the first and second sets of power rails (44, 46).

7. The integrated circuit device (10) according to claim 6, wherein the clock mesh (32), the first set of power rails (44) and the second set of power rails (46) are arranged in consecutive metallization layers (BSM2, BSM1, BSM3) of the backside interconnect structure (20).

8. The integrated circuit device (10) according to any one of claims 4-7, wherein the first set of clock lines (34) and the first set of power rails (44) extend along a first direction (Y) and the second set of clock lines (36) and the second set of power rails (46) extend along a second direction (X) transverse to the first direction (Y).

9. The integrated circuit device (10) according to claim 8, wherein the first set of power rails (44) are arranged at a first power rail pitch (PP1) and the first set of clock lines (34) are arranged at a first clock line pitch (PC1) defined by one or more integer multiples of the first power rail pitch (PP1), and wherein the second set of clock lines (36) are arranged at a second clock line pitch (PC2) and the second set of power rails (46) are arranged at a second power rail pitch (PP2) defined by one or more integer multiples of the second clock line pitch (PC2).

10. The integrated circuit device (10) according to any one of claims 8-9, wherein the first set of power rails (44) are offset along the second direction (X) with respect to the first set of clock lines (34), and/or wherein the second set of power rails (46) are offset along the first direction (Y) with respect to the second set of clock lines (36).

11. The integrated circuit device (10) according to claim 10, when dependent on claim 9, wherein the offset of the first set of power rails (44) with respect to the first set of clock lines (34) is substantially equal to half of the first power rail pitch (PP1), and wherein the offset of the second set of power rails (46) with respect to the second set clock lines (36) is substantially equal to half of the second clock line pitch (PC2).

12. The integrated circuit device (10) according to any one of claims 10-11, wherein the backside interconnect structure (20) further comprises at least one power via (60) connected to a power rail (44) of the first set of power rails (44) and to a power rail (46) of the second set of power rails (46) and extending through an opening in the clock mesh (32).

13. The integrated circuit device (10) according to any one of claims 10-12, wherein the backside interconnect structure (20) further comprises at least one clock via (50) connected to the clock distribution network (20) and extending through an opening in the first set of power rails (44).

14. The integrated circuit device (10) according any one of the preceding claims, wherein the integrated circuit (10) device further comprises a substrate (12) supporting, on a frontside (12a) thereof, an active device region (14), and a frontside interconnect structure (16) arranged above the active device region (14), wherein the backside interconnect structure (20) is arranged on a backside (12b) of the substrate (12).

15. The integrated circuit device (10) according to claims 13 and 14, wherein the at least one clock via (50) extends through the substrate (12) and is connected to clock driver circuitry of the active device region (14).
